# EUROPÄISCHE PATENTSCHRIFT

(11) **EP 3 555 563 B1**
(45) Veröffentlichungstag und Bekanntmachung des Hinweises auf die Patenterteilung: **06.09.2023**
(21) Anmeldenummer: 17797362.5
(22) Anmeldetag: 14.11.2017
(51) Int. Cl.: G01C 15/00, H01S 5/00

(54) **VERFAHREN ZUR HERSTELLUNG EINES LASERMODULS EINER LASER-NIVELLIERVORRICHTUNG SOWIE LASER-NIVELLIERVORRICHTUNG**
METHOD FOR PRODUCING A LASER MODULE OF A LASER LEVELLING DEVICE, AND LASER LEVELLING DEVICE
PROCÉDÉ DE FABRICATION D'UN MODULE LASER D'UN DISPOSITIF DE NIVELLEMENT À LASER AINSI QUE DISPOSITIF DE NIVELLEMENT À LASER

(30) Priorität: 16.12.2016 DE 102016225242
(43) Veröffentlichungstag der Anmeldung: 23.10.2019
(73) Patentinhaber: Robert Bosch GmbH, 70442 Stuttgart (DE)
(72) Erfinder: APELT, Stefan, 70839 Gerlingen (DE)
(86) Internationale Anmeldenummer: PCT/EP2017/079164
(87) Internationale Veröffentlichungsnummer: WO 2018/108411

(56) Entgegenhaltungen:
- EP-A2- 1 296 163
- CN-A- 104 655 109
- DE-U1-202009 018 893

## Beschreibung

### Stand der Technik

Die Erfindung betrifft ein Verfahren zur Herstellung eines Lasermoduls einer Laser-Nivelliervorrichtung mittels Kunststoff-Spritzgießtechnik. Des Weiteren betrifft die Erfindung eine derartige Laser-Nivelliervorrichtung.

Aus der EP 2411762 A1 ist eine Laser-Nivelliervorrichtung zum Erzeugen eines optischen Nivelliersignals bekannt, die ein in einem Gehäuse pendelbar anordenbares Lasermodul zur Erzeugung eines Nivelliersignals aufweist. Das Nivelliersignal wird bei einer derartigen Laser-Nivelliervorrichtung durch Aufspalten eines von einer Laserdiode erzeugten Laserlichts in eine 360°-Laserebene durch Beleuchtung eines kegelförmigen Reflektors (beispielsweise eines reflektierenden Kegels) erzeugt. In Folge der pendelbaren Aufhängung des Lasermoduls kann derart ein horizontales oder vertikales, in einen Winkelbereich von 360° emittiertes Nivelliersignal realisiert sein. Ferner sind aus EP 1296163 A2, DE 2020/09018893 U1 und CN 104655109 A Lasermodule bekannt, die zu einer Funktionsintegration von optischen Komponenten dienen.

### Offenbarung der Erfindung

Die aus dem Stand der Technik bekannten Laser-Nivelliervorrichtungen müssen zur koaxialen Ausrichtung des von der Laserdiode emittierten Laserlichts sowie der Kegelachse des kegelförmigen Reflektors zueinander aufwändig justiert werden, sodass der Lichtstahl der Laserdiode und der kegelförmige Reflektor exakt koaxial zueinander ausgerichtet sind. Hierzu wird typischerweise der kegelförmige Reflektor mit Hilfe eines transparenten Abstandshalters über der Laserdiode fixiert und ausgerichtet, insbesondere fokussiert. Nach erfolgter Ausrichtung, insbesondere Fokussierung, wird der kegelförmige Reflektor mit dem Abstandshalter verklebt und derart langzeitstabil befestigt. Durch die Aushärtung und eine damit möglicherweist verbundene Schwindung (Schrumpfung) des Klebers kann es zu einer Defokussierung der zueinander ausgerichteten Komponenten führen.

Das vorgeschlagene Herstellungsverfahren für ein Lasermodul einer Laser-Nivelliervorrichtung geht aus von einem Lasermodul, das dazu vorgesehen ist, eine projizierbare Laserlinie, insbesondere eine über einen Winkelbereich von 360° projizierbare Laserlinie, zu erzeugen und zumindest eine Laserdiode zur Emission eines Laserstrahls in Emissionsrichtung aufweist.

"Laser-Nivelliervorrichtungen" dienen der Erzeugung von optischen Markierungen, insbesondere Lasermarkierungen, im Rahmen von Nivellier-, Ausricht-, Vermessungs- und/oder Markierungsaufgaben, wie sie insbesondere im handwerklichen Bereich auftreten, beispielsweise bei einem Innenausbau von Gebäuden, bei Bauarbeiten, bei der Anbringung von Markierungen an Wänden oder dergleichen. Prinzipiell erlauben Laser-Nivelliervorrichtungen Lasermarkierungen zu erzeugen, insbesondere auf Objekte zu projizieren, die eine von einer Ausrichtung von Böden, Decken, Wänden oder anderen Gegenständen, beispielsweise der vertikalen Wand eines Schranks, insbesondere aber auch eine von der Ausrichtung des Gehäuses der Laser-Nivelliervorrichtung, unabhängige Referenz darstellen. Grundsätzlich erlauben Laser-Nivelliervorrichtungen in zumindest einem Betriebszustand eine am Gravitationsfeld, d.h. eine an der Richtung der Schwerkraft oder eine bezogen auf das Lot, ausgerichtete Lasermarkierung als Referenz zu erzeugen. Insbesondere kann die erzeugte Lasermarkierung bezogen auf die Laser-Nivelliervorrichtung beispielsweise horizontal und/oder vertikal und/oder unter einem anderen definierten Winkel zum Lot ausgerichtet sein. Dazu weisen Laser-Nivelliervorrichtungen typischerweise ein Gehäuse mit mindestens einer Öffnung, insbesondere einem Fenster auf, wobei in dem Gehäuse zumindest eine Pendelanordnung angeordnet ist. Die Pendelanordnung, insbesondere das umfasste Pendel der Pendelanordnung, ist zum Halten sowie Ausrichten mindestens eines Lasermoduls vorgesehen, wobei das Lasermodul mittels des Pendels der Pendelanordnung im Wesentlichen unabhängig von einer Ausrichtung des Gehäuses am Lot frei selbst-ausrichtbar, insbesondere allseitig pendelbar oder schwingend, ausgebildet ist. Das Lasermodul dient bei dessen Betrieb der Erzeugung zumindest einer Lasermarkierung auf einem Objekt.

Unter "vorgesehen" soll insbesondere speziell "programmiert", "ausgelegt" und/oder "ausgestattet" verstanden werden. Darunter, dass ein Objekt zu einer bestimmten Funktion "vorgesehen" ist, soll insbesondere verstanden werden, dass das Objekt diese bestimmte Funktion in zumindest einem Anwendungs- und/oder Betriebszustand erfüllt und/oder ausführt oder dazu ausgelegt ist, die Funktion zu erfüllen.

Das Lasermodul weist zumindest eine Lichtquelle zur Erzeugung einer Lasermarkierung auf einem Objekt auf, insbesondere einen Laser, einen Halbleiterlaser, typischerweise eine Laserdiode. Ebenfalls weist das Lasermodul zumindest einen Strahlteiler auf, der dazu vorgesehen ist, aus dem von der Laserdiode emittierten Laserlicht eine projizierbare Laserlinie, insbesondere eine über einen Winkelbereich von 360° projizierbare Laserlinie, zu erzeugen. Ferner kann das Lasermodul weitere strahlformende und/oder strahllenkende und/oder die Eigenschaften des Laserlichts beeinflussende optische Element, beispielsweise Linsen, Filter, diffraktive Elemente, Spiegel, Reflektoren, optisch transparente Scheiben oder dergleichen, aufweisen. Insbesondere reflektierende Kegel können genutzt werden, um technisch einfach eine Auffächerung des von der Lichtquelle emittierten Laserlichts zu einer Laserebene zu realisieren, sodass bei Projektion dieser Laserebene auf einen Gegenstand eine Linie, insbesondere eine Markierungslinie, bevorzugt eine über einen Winkelbereich von 360° projizierbare Laserlinie, entsteht.

Die genaue Ausgestaltung, insbesondere Form und Farbe, der mittels der Laser-Nivelliervorrichtung, insbesondere mittels des Lasermoduls, erzeugten Lasermarkierung kann, unter anderem je nach Einsatzbereich und Aufgabe, unterschiedlich sein. So kann beispielsweise der Winkelbereich, in den das Laserlicht in Form einer Laserebene ("Laserfächer") emittiert wird, auch von 360° abweichen und beispielsweise nur einen Winkelbereich von 270° oder 180° abdecken. Ferner kann die Laserebene auch über den Winkelbereich unterbrochen sein, beispielsweise auf Grund von Abschattungen oder dergleichen, insbesondere von Teilen des Gehäuses der Laser-Nivelliervorrichtung herrühren.

Ferner kann die Laser-Nivelliervorrichtung auch mehrere, insbesondere zwei oder drei, Lasermodule aufweisen, die jeweils an dem Pendel aufgenommen sind, sodass bei Ausrichtung des Pendels am Lot zeitgleich mehrere Lasermodule und damit auch deren erzeugte Laserebenen bezogen auf das Lot ausgerichtet werden und als Referenz dienen können. In einer Ausführungsform kann die Laser-Nivelliervorrichtung auch zwei oder drei Lasermodule aufweisen, die zueinander orthogonale Laserebenen emittieren, deren Projektion auf Objekte jeweils zueinander orthogonale Markierungslinien erzeugt. Dabei kann eine vertikal ausgerichtete Laserebene eine entlang der durch das Lot vorgegebenen Richtung aufweisen, d.h. die vertikal ausgerichtete Laserebene ist kollinear mit einem die Schwerkraft beschreibenden Vektor.

Ferner weist die Laser-Nivelliervorrichtung des Weiteren eine Vorrichtung auf, die dazu vorgesehen ist, die Laser-Nivelliervorrichtung zur Inbetriebnahme und während des Betriebs mit elektrischer Energie zu versorgen, beispielsweise einen stromnetzunabhängigen Energiespeicher wie eine Batterie oder einen Akkumulator. Dem Ein- und Ausschalten der Laser-Nivelliervorrichtung dient ein insbesondere am Gehäuse angeordneter Schalter oder ein alternatives Element, das diese Funktion erfüllt. Des Weiteren können weitere, einem Fachmann sinnvoll erscheinende Ausführungen vorgesehen sein, beispielsweise ein weiterer Schalter, der der Arretierung des Pendels in dem Gehäuse, insbesondere zu Transportzwecken oder zur Verkippung der Laser-Nivelliervorrichtung nach erfolgtem Auspendeln des Pendels, dient.

Das erfindungsgemäße Herstellungsverfahren für ein Lasermodul einer Laser-Nivelliervorrichtung weist zumindest einen Verfahrensschritt auf, bei dem ein Strahlteiler des Lasermoduls mittels Kunststoff-Spritzgießtechnik in Form eines zur Totalreflektion vorgesehenen Negativ-Kegels einstückig, insbesondere form-, kraft- und/oder stoffschlüssig, mit der Laserdiode gefertigt wird. Dazu wird die Laserdiode zunächst in ein Spritzgießwerkzeug, insbesondere in eine Spritzgießform, eingelegt und positioniert. Anschließend wird nach Schließen des Spritzgießwerkzeugs im Spritzgießverfahren der Strahlteiler durch Einspritzen und anschließendes Aushärten eines Kunststoffmaterials als entstehender Negativ-Kegel direkt an die Laserdiode angebunden. Bevorzugt umfließt das eingespritzte Kunststoffmaterial die Laserdiode oder zumindest Teile der Laserdiode im Spritzgießwerkzeug und führt zu einer Anbindung an diese. Somit wird der Negativ-Kegel einstückig, insbesondere form-, kraft- und/oder stoffschlüssig, mit der Laserdiode oder zumindest mit Teilen der Laserdiode gefertigt. Der einfließende Kunststoff formt ferner in Folge der Abformung des Spritzgießwerkzeugs den Negativ-Kegel aus. In einer Ausführungsform des Herstellungsverfahrens wird der Strahlteiler in Form des Negativ-Kegels durch Umspritzen eines Positiv-Kegels gefertigt.

Das Umspritzen oder Umfließen der Laserdiode mit Kunststoff meint insbesondere nicht notwendigerweise das vollständige Umhüllen der Laserdiode mit Kunststoff, sondern vielmehr die Anbindung des einfließenden Kunststoffs an zumindest eine Komponente der Laserdiode durch um-, an- bzw. einspritzen und anschließendes, bevorzugt passgenaues, Aushärten des Kunststoffs, wobei die Funktionalität der Laserdiode uneingeschränkt erhalten bleibt. Bevorzugt ist das Spritzgießwerkzeug vorgesehen, insbesondere geformt, um eine Herstellung des Lasermoduls in erfindungsgemäßem Herstellungsverfahren zu gewährleisten. Das in erfindungsgemäßem Verfahrensschritt gefertigte Lasermodul wird anschließend, nach Aushärtung, dem Spritzgießwerkzeug entnommen.

Unter einem "zur Totalreflektion vorgesehenen Negativ-Kegel" ist ein Strahlteiler zu verstehen, bei dem im Gegensatz zu Systemen aus dem Stand der Technik die Strahlaufteilung nicht durch Reflektion an einer verspiegelten Fläche erfolgt, sondern durch Ausnutzung des Effekts der Totalreflektion des in einen transparenten Kunststoff eingekoppelten Laserlichts.

Das Lasermodul stellt somit ein aus zumindest der Laserdiode und dem Strahlteiler bestehendes, einstückiges Bauteil dar. "Einstückig" bedeutet in diesem Kontext, dass die Laserdiode und der Strahlteiler zwar nicht notwendigerweise aus einem einzigen und einheitlichen Teil und/oder Material gefertigt werden, jedoch im Spritzgießverfahren als fest und innig, insbesondere form-, und/oder stoffschlüssig, miteinander verbunden gefertigt werden, sodass sie bevorzugt nicht als mehrere aneinander gefügte Bauteile erscheinen und jedenfalls nicht mehr voneinander gelöst werden können, ohne dabei zerstört zu werden.

Durch die Integration von Strahlteiler und Laserdiode in einem integrierten Bauteil, welches mittels Kunststoff-Spritzgießtechnik in Form eines zur Totalreflektion vorgesehenen Negativ-Kegels ausgebildet ist, kann ein wirtschaftlich besonders günstiges Verfahren zur Herstellung eines besonders robusten Lasermoduls angegeben werden, wobei das Lasermodul zur Erzeugung projizierbare Laserlinie, insbesondere eine über einen Winkelbereich von 360° projizierbare Laserlinie, vorgesehen ist. Insbesondere ist das derart realisierte Lasermodul besonders langzeitstabil, stabil gegenüber mechanischen Einflüssen und stabil gegenüber thermischen Schwankungen.

Vorteilhaft lassen sich durch die gezielte Funktionsintegration in einem Bauteil des Lasermoduls, d.h. von Laserlichterzeugung durch die Laserdiode und Laserlichtaufspaltung durch den Strahlteiler in Form eines Negativ-Kegels, sowie durch funktionsgerechten Materialeinsatz das Herstellungsverfahren auf möglichst wenige Prozessschritte und besonders wenigen Einzelkomponenten reduzieren. Insbesondere lässt sich auf diese Weise mit lediglich einem Verfahrensschritt des Herstellungsverfahrens ein Lasermodul herstellen, bei dem die Anzahl verwendeter Bauteile oder Komponenten minimiert ist. Demnach sind keine aufwendige Herstellung von Einzelkomponenten sowie keine Montage von Einzelkomponenten durchzuführen, sodass das Herstellungsverfahren vorteilhaft beschleunigt und wirtschaftlich gestaltet wird. Ferner kann das Lasermodul besonders kleinbauend und somit platzsparend ausgeführt sein. Ferner kann auch der Kostenaufwand für Arbeits- und Anlagenkosten sowie der Zeitaufwand für Herstellung und Logistik des Lasermoduls vorteilhaft reduziert werden.

Ferner kann durch die Fertigung des Lasermoduls nach erfindungsgemäßem Herstellungsverfahren besonders vorteilhaft auf aufwendige Bearbeitungs- und/oder Justierschritte, bei denen Einzelkomponenten im Herstellungsverfahren der Laser-Nivelliervorrichtung zeit- und kostenintensiv möglichst präzise positioniert und in ihren Anordnungen zueinander aufwendig angepasst werden, verzichtet werden. Da im erfindungsgemäßen Herstellungsverfahren die Laserdiode und der Strahlteiler mittels Kunststoff-Spritzgießtechnik aufeinander aufbauend und aufeinander angepasst hergestellt werden, muss keine Anpassung von Positionen sowie keine Anpassung von Ausrichtungen zweier getrennter Komponenten in typischerweise aufwendigen Justageprozessen durchgeführt werden. Besonders vorteilhaft wird auf diese Weise eine Funktionsintegration von Komponenten direkt im Herstellungsverfahren durchgeführt, mit der Folge, dass Fehler, insbesondere auch Fertigungstoleranzen, minimiert werden und die Herstellung der Laser-Nivelliervorrichtung hinsichtlich Korrektur und/oder Ausgleich von Fertigungstoleranzen vereinfacht und beschleunigt wird. Insbesondere liegen die Fertigungstoleranzen in erfindungsgemäßem Herstellungsverfahren unter 1 mm, bevorzugt unter 1/10 mm, besonders bevorzugt unter 1/100 mm. Das erfindungsgemäße Herstellungsverfahren erlaubt daher eine besonders wirtschaftliche und schnelle, gleichzeitig aber auch besonders definierte, präzise und reproduzierbare Herstellung eines Lasermoduls.

In einer Ausführungsform des Herstellungsverfahrens ist der Positiv-Kegel im Wesentlichen, bevorzugt komplett, als ein gerader, insbesondere rotationssymmetrischer, Kreiskegel ausgebildet. In einer Ausführungsform des Herstellungsverfahrens ist der Positiv-Kegel im Wesentlichen, bevorzugt komplett, als ein gerader, insbesondere rotationssymmetrischer, Kreiskegel mit einem Kegelöffnungswinkel von 90° ausgebildet.

In einer alternativen Ausführungsform des Herstellungsverfahrens ist der Positiv-Kegel als ein, insbesondere rotationssymmetrischer, Kegel mit einer zumindest abschnittsweise konkav-gekrümmt ausgebildeten Mantellinie ausgebildet ist. In einer Ausführungsform des Herstellungsverfahrens ist der Positiv-Kegel als ein, insbesondere rotationssymmetrischer, Kegel mit einer konkav-parabelförmig ausgebildeten Mantellinie ausgebildet.

In einer alternativen Ausführungsform des Herstellungsverfahrens besteht der Positiv-Kegel in seiner Form aus zumindest einem, insbesondere rotationssymmetrischen, Kreiskegelstumpf, auf dessen schmaler Stirnfläche ein, insbesondere rotationssymmetrischer, Kreiskegel angeschlossen ist. Insbesondere können die beiden Kegelabschnitte - Kegelstumpf und daran angeschlossener Kegel - als gerade, insbesondere rotationssymmetrische, Kreiskegel ausgebildet sein. Insbesondere kann dabei die Kegelspitze einen Kegelöffnungswinkel von weniger als 90° aufweisen, während der Kegelstumpf einen Kegelöffnungswinkel von mehr als 90° aufweist. Insbesondere kann die Kegelspitze auch einen Kegelöffnungswinkel von 90° aufweisen, während der Kegelstumpf einen Kegelöffnungswinkel von mehr als 90° aufweist.

Alternativ kann können die beiden Kegelabschnitte - Kegelstumpf und daran angeschlossener Kegel - mit einer zumindest abschnittsweise konkav-gekrümmt ausgebildeten Mantellinie, insbesondere einer konkav-parabelförmig ausgebildeten Mantellinie, ausgebildet sein. Dabei kann die Kegelspitze einen Kegelöffnungswinkel von weniger als 90° aufweisen, während der Kegelstumpf einen Kegelöffnungswinkel von mehr als 90° aufweist. Insbesondere kann die Kegelspitze auch einen Kegelöffnungswinkel von 90° aufweisen, während der Kegelstumpf einen Kegelöffnungswinkel von mehr als 90° aufweist.

In einer beispielhaften Ausführungsform weist der Kegelstumpf einen Kegelöffnungswinkel von 145° auf, während die Kegelspitze einen Kegelöffnungswinkel von 70° aufweist.

Ferner sind dem Fachmann weitere Ausführungen der technischen Lehre zugänglich, beispielsweise die Ausbildung eines dreigliedrigen Positiv-Kegels bestehend aus zwei Kegelstümpfen und einer Kegelspitze, wobei der Kegelöffnungswinkel in Richtung Kegelspitze abnimmt.

In einer Ausführungsform des Herstellungsverfahrens werden die Laserdiode und der zu umspritzende Positiv-Kegel in einem weiteren Verfahrensschritt, insbesondere einem dem Verfahrensschritt des Spritzgießens vorausgehenden Verfahrensschritt, mittels einer Justiervorrichtung derart zueinander ausgerichtet, dass die Kegelachse des Positiv-Kegels und die Emissionsrichtung der Laserdiode kollinear sind. Insbesondere wird in diesem weiteren Verfahrensschritt die Laserdiode bezüglich des zu umspritzenden Positiv-Kegels derart ausgerichtet, dass die Kegelachse des Positiv-Kegels und die Emissionsrichtung der Laserdiode kollinear sind. Die Justiervorrichtung ist beweglich und kann, insbesondere durch einen mechanischen oder elektrischen Antrieb, sehr genau verstellt werden. Auf diese Weise kann bereits während des Herstellungsverfahrens sichergestellt werden, dass die Laserdiode und der zu formende Strahlteiler möglichst präzise positioniert und in ihren Anordnungen zueinander abgestimmt sind. Somit kann ein Lasermodul bereitgestellt werden, das eine Laserebene ("Laserfächer") emittiert, insbesondere über einen Winkelbereich von 360° emittiert, wobei die Laserebene eine geometrisch besonders präzise Ebene darstellt. Folglich ist auch eine mittels der Laservorrichtung projizierbare Laserlinie, insbesondere eine über einen Winkelbereich von 360° projizierbare Laserlinie, erzeugbar, die geometrisch als besonders linear - d.h. keine Welligkeit aufweisend - betrachtet werden kann.

Unter "kollinear" ist insbesondere auch "koaxial" zu verstehen.

In einer Ausführungsform des Herstellungsverfahrens wird die Laserdiode während des Verfahrensschritts der Ausrichtung betrieben. Hierfür ist die Laserdiode insbesondere elektrisch kontaktiert. Insbesondere ist hierfür vorgesehen, dass elektrische Leitungen in das Spritzgießwerkzeug hineinragen oder dass die elektrischen Kontakte der Laserdiode aus dem Spritzgießwerkzeug herausragen. Somit kann insbesondere erreicht werden, dass die Laserdiode anhand des tatsächlich emittierten Laserlichts justiert wird und nicht nur anhand des Gehäuses der Laserdiode. Es sei darauf hingewiesen, dass die Richtung, in die Laserlicht von der Laserdiode emittiert wird, prinzipiell geringfügig von einer auf Grund der Gehäuseform der Laserdiode zu erwartenden Richtung abweichen kann. Folglich kann die Laserdiode erfindungsgemäß genauer justiert werden, indem die Kegelachse des Positiv-Kegels und die tatsächliche Emissionsrichtung der Laserdiode kollinear zueinander ausgerichtet werden. Ferner ist folglich auch eine mittels der Laservorrichtung projizierbare Laserlinie, insbesondere eine über einen Winkelbereich von 360° projizierbare Laserlinie, erzeugbar, die geometrisch als besonders linear - d.h. keine Welligkeit aufweisend - betrachtet werden kann.

In einer Ausführungsform des Herstellungsverfahrens wird der von der im Spritzgießwerkzeug befindlichen Laserdiode während ihres Betriebs emittierte Laserstrahl am Positiv-Kegel geteilt und in unterschiedliche Richtungen reflektiert, wobei eine Position des reflektierten Laserlichts mittels zumindest zweier, bevorzugt dreier, lichtempfindlicher Sensoren detektiert wird. In einer Ausführungsform können die zumindest zwei, bevorzugt drei, lichtempfindlichen Sensoren auf der Düsenseite des Werkzeugs vorgesehen sein. Die lichtempfindlichen Sensoren dienen der Detektion von auf die Sensoren auftreffendem reflektierten Laserlicht. Dabei soll unter einem lichtempfindlichen Sensor zumindest ein im Wellenlängenbereich des Laserlichts empfindliches Detektorelement wie beispielsweise eine Photodioden, eine PIN-Diode, eine Avalanche Photo Diode (APD), eine Single-Photon-Avalanche-Diode (SPAD), (modulierte) CCD-Chips und CMOS-Pixel verstanden werden, das abhängig von einer auftreffenden Lichtintensität ein Detektionssignal liefert. In einer Ausführungsform kann ein lichtempfindlicher Sensor auch jeweils als ein ortsauflösendes Array von Detektorelementen, beispielsweise in Form eines CMOS-Chips oder eines CCD-Chips, realisiert sein. Insbesondere lässt sich unter Verwendung der zumindest zwei, bevorzugt drei, lichtempfindlichen Sensoren die Position des reflektierten Laserlichts in Richtung eines jeweiligen Sensors detektiert. In einer Ausführungsform sind die zumindest zwei, bevorzugt drei, lichtempfindlichen Sensoren als ortsauflösende Sensoren realisiert. Insbesondere liegen die zwei, bevorzugt drei Sensoren jeweils in der Laserebene - d.h. unter einem rechten Winkel zur Kegelachse des Positiv-Kegels - und sind unter einem Winkel zueinander rotationssymmetrisch um die Kegelachse des Positiv-Kegels angeordnet, wobei die Sensoren jeweils auf den Positiv-Kegel ausgerichtet sind. Der Winkel, unter dem die Sensoren zueinander rotationssymmetrisch um die Kegelachse des Positiv-Kegels angeordnet sind, kann beispielsweise 90° bei zwei Sensoren betragen und jeweils 120° bei drei Sensoren. Andere Winkelstellungen zueinander sind denkbar. Bei idealer, d.h. kollinearer, Ausrichtung von Laserdiode bezüglich Positiv-Kegel werden die drei ortsauflösenden Sensoren jeweils an einer vorbestimmten Position, beispielsweise in der Sensormitte, von dem reflektierten Laserlicht getroffen.

In einer Ausführungsform des Herstellungsverfahrens erfolgt die Ausrichtung unter Verwendung einer automatisierten Justiervorrichtung, wobei die Justiervorrichtung unter Anwendung einer mit den Sensoren gekoppelten Regelschleife oder Steuerschleife betrieben wird. Auf diese Weise kann das mittels der Laserdiode erzeugte Laserlicht an dem Positiv-Kegel reflektiert und somit aufgespalten werden, wobei es in Richtung der zumindest zwei lichtempfindlichen Sensoren umgelenkt wird. Das Laserlicht wird dabei mittels der zumindest zwei Sensoren detektiert.

Die Justiervorrichtung wird in einer Ausführungsform des Verfahrens so lange verfahren, bis die Kegelachse des Positiv-Kegels und die Emissionsrichtung der Laserdiode kollinear zueinander positioniert bzw. ausgerichtet sind (,passive alignment'). In einer alternativen Ausführungsform des Verfahrens wird mit Hilfe eines Steueralgorithmus, beispielsweise unter Verwendung eines Bildverarbeitungsalgorithmus, eine Information über eine Abweichung des reflektierten Laserlichts von einer Sollposition oder Zielposition ermittelt. Insbesondere kann beispielsweise ein lateraler Abstand des auf einen ortsauflösenden Sensor projizierten Laserlichts von der Mitte des jeweiligen Sensors ermittelt werden. Unter Verwendung dieser Information kann anschließend eine Ansteuerung der Justiervorrichtung erfolgen. Die Auslesung der Sensoren, die Bestimmung der Information über die Abweichung sowie die Ansteuerung der Justiervorrichtung kann dabei insbesondere in einer Regelschleife realisiert sein. Die Regelschleife dient der sukzessiven Reduzierung des Abstands des auf die jeweilige Sensoroberfläche projizierten Laserlichts von der Mitte des jeweiligen Sensors. Durch Reduzieren dieses Abstands wird gleichzeitig die Kegelachse des Positiv-Kegels und die Emissionsrichtung der Laserdiode kollinear zueinander positioniert bzw. ausgerichtet (,active alignment').

In einer Ausführungsform des Herstellungsverfahrens wird die Ausrichtung von Laserdiode und des zu umspritzenden Positiv-Kegels beendet, wenn die Position des reflektierten Laserlichts vorbestimmte Positionen einnimmt. Insbesondere sind die vorbestimmten Positionen des reflektierten Laserlichts derart definiert, dass sie exakt dann eingenommen werden, wenn die Kegelachse des Positiv-Kegels und die Emissionsrichtung der Laserdiode kollinear zueinander positioniert bzw. ausgerichtet sind. Auf diese Weise kann sichergestellt werden, dass nach Abschluss des weiteren Verfahrensschritts die Laserdiode und die Kegelachse derart zueinander ausgerichtet sind, dass sie kollinear sind.

Nach Abschluss des weiteren Verfahrensschritts wird der Strahlteiler des Lasermoduls mittels Kunststoff-Spritzgießtechnik gefertigt.

In einer Ausführungsform des Herstellungsverfahrens besitzt der Positiv-Kegel eine Oberflächenrauigkeit von weniger als 10 nm, bevorzugt von weniger als 5 nm und besonders bevorzugt von weniger als 1 nm besitzt. Auf diese Weise wird erreicht, dass der im erfindungsgemäßen Herstellungsverfahren gefertigte Negativ-Kegel ebenfalls eine besonders geringe Oberflächenrauigkeit aufweist. Diese Oberflächenrauigkeit des Negativ-Kegels beträgt insbesondere ebenfalls weniger als 10 nm, bevorzugt weniger als 5 nm und besonders bevorzugt von weniger als 1 nm besitzt. Auf diese Weise kann ein Lasermodul realisiert werden, dass eine besonders brillante, helle und präzise Laserebene, insbesondere über einen Winkelbereich von 360°, erzeugt.

In einer Ausführungsform des Herstellungsverfahrens wird der Strahlteiler aus transparentem Kunststoff, insbesondere aus thermoplastischem oder aus vernetzendem Kunststoff, mittels Kunststoff-Spritzgießtechnik gefertigt. Transparente Thermoplaste stellen dabei einen Kompromiss aus mechanischer Verformbarkeit, thermischer und mechanischer Stabilität sowie Transparenz dar, die zur Erreichung und Einhaltung sehr enger Toleranzanforderungen des Bauteils vorteilhaft sind. Die Transparenz des Thermoplasts ist zumindest teilweise notwendig, um den mittels des Thermoplasts geformten Negativ-Kegel für interne Totalreflektion geeignet zu machen. Darüber hinaus zeichnet sich thermoplastischer Kunststoff durch die Fähigkeit zur Absorption mechanischer Einflüsse, insbesondere beispielsweise von Stößen und Vibrationen oder dergleichen, aus. Ferner härtet auch thermoplastischer Kunststoff unter Einfluss erhöhter Temperaturen aus. In einer Ausführungsform kann der transparente thermoplastische Kunststoff beispielsweise als Acrylglas (Polymethylmetacrylate, PMMA), Polycarbonat (PC), Polyvinylchlorid (PVC), Polystyrol (PS), Polyphenylenether (PPO), Polyetherimid (PEI), Polymethylpenten (PMP), Polysulfon (PSU), Polyethylen (PE) oder Cyclo Olefin Polymer (COP) gewählt sein. Alternativ kann transparenter, vernetzender Kunststoff wie beispielsweise Liquid-Silicone-Rubber (LSR), Polyurethane oder Epoxidharz (EP) eingesetzt werden. Weitere transparente Kunststoffe zur Verwendung in erfindungsgemäßem Herstellverfahren sind denkbar.

Nach Durchführen des Spritzgießverfahrens und einer Kühl- und/oder Aushärtezeit wird das Spritzgießwerkzeug geöffnet und die Laserdiode mit integriertem optischen Element entnommen.

Ferner wird ein erfindungsgemäßes Lasermodul für eine Laser-Nivelliervorrichtung vorgeschlagen, das nach dem vorhergehenden Herstellungsverfahren hergestellt ist.

Ferner wird eine erfindungsgemäße Laser-Nivelliervorrichtung vorgeschlagen, die zumindest ein Gehäuse, ein in dem Gehäuse, insbesondere mittels einer Pendelaufhängung, pendelbar angeordnetes Pendel sowie zumindest ein an dem Pendel angeordnetes Lasermodul aufweist. Das Lasermodul ist dabei zur Erzeugung einer projizierbaren Laserlinie, insbesondere einer über einen Winkelbereich von 360° projizierbaren Laserlinie, vorgesehen und nach dem vorhergehenden Herstellungsverfahren hergestellt.

Auf diese Weise kann eine wirtschaftlich besonders günstig herstellbare Laser-Nivelliervorrichtung angegeben werden, da auf eine aufwendige Montierung unter Verwendung einer Vielzahl von Einzelschritten und/oder einer Vielzahl von Einzelbauteilen sowie Werkzeugen verzichtet werden kann. Ebenfalls ist eine präzise Ausrichtung der emittierten Laserebene bereits in den vorherigen Verfahrensschritten durchgeführt worden, sodass ein langwieriges Austarieren und Justieren nach der Montierung der Laserdiode an dem Pendel der Laser-Nivelliervorrichtung vermieden wird. Folglich stellt sich die Montierung der Laser-Nivelliervorrichtung besonders definiert, präzise und reproduzierbar, somit also auch besonders einfach und wirtschaftlich vorteilhaft, dar.

Es sei darauf hingewiesen, dass die erfindungsgemäße Laser-Nivelliervorrichtung nicht auf die Verwendung eines Lasermoduls beschränkt zu verstehen ist. Vielmehr kann auch eine Laser-Nivelliervorrichtung angegeben werden, die zwei oder drei oder auch mehr Lasermodule beinhaltet, sodass mittels der Laser-Nivelliervorrichtung zwei oder drei oder auch projizierbare Laserlinien, insbesondere Laserebenen, die jeweils beispielsweise einen Winkelbereich von 360° abdecken, erzeugt werden können.

### Zeichnungen

Die Erfindung ist anhand von in den Zeichnungen dargestellten Ausführungsbeispielen in der nachfolgenden Beschreibung näher erläutert. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen. Gleiche Bezugszeichen in den Figuren bezeichnen gleiche Elemente.

Es zeigen:
- Figur 1: eine perspektivische Darstellung einer Ausgestaltung der erfindungsgemäßen Laser-Nivelliervorrichtung
- Figur 2: eine seitliche Ansicht der Ausgestaltung der erfindungsgemäßen LaserNivelliervorrichtung nach Figur 1 mit einem teilweise geöffneten Gehäuse
- Figur 3: schematische Schnittansichten erfindungsgemäßer Lasermodule mit unterschiedliche geformten Strahlteilern (a, c, d) sowie mit eingezeichnetem Lichtpfad (b)
- Figur 4: ein Verfahrensdiagramm einer Ausgestaltung des erfindungsgemäßen Herstellungsverfahrens
- Figur 5: eine schematische Schnitt-Ansicht einer Ausgestaltung eines Spritzgießwerkzeugs, in dem sich eine Laserdiode befindet

### Beschreibung der Ausführungsbeispiele

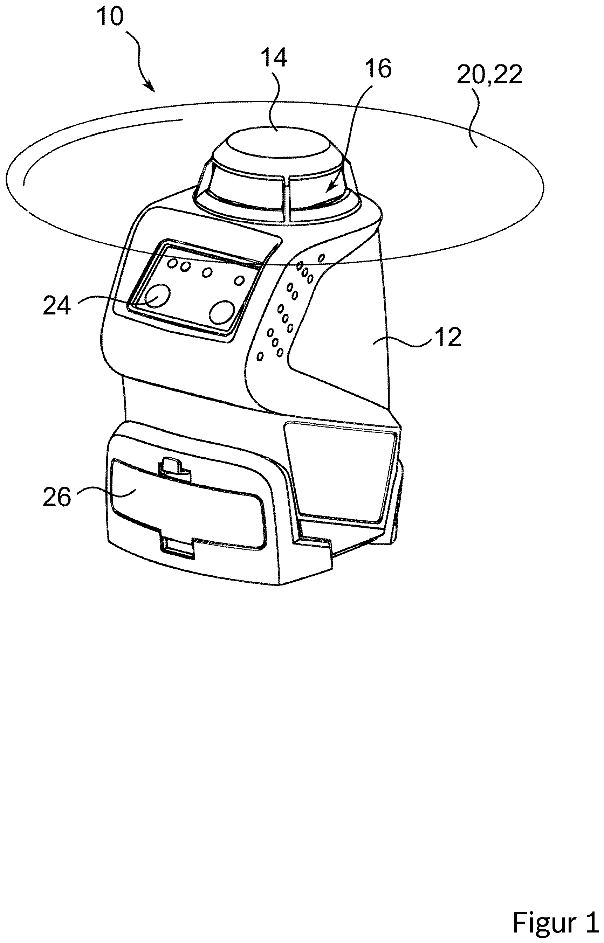

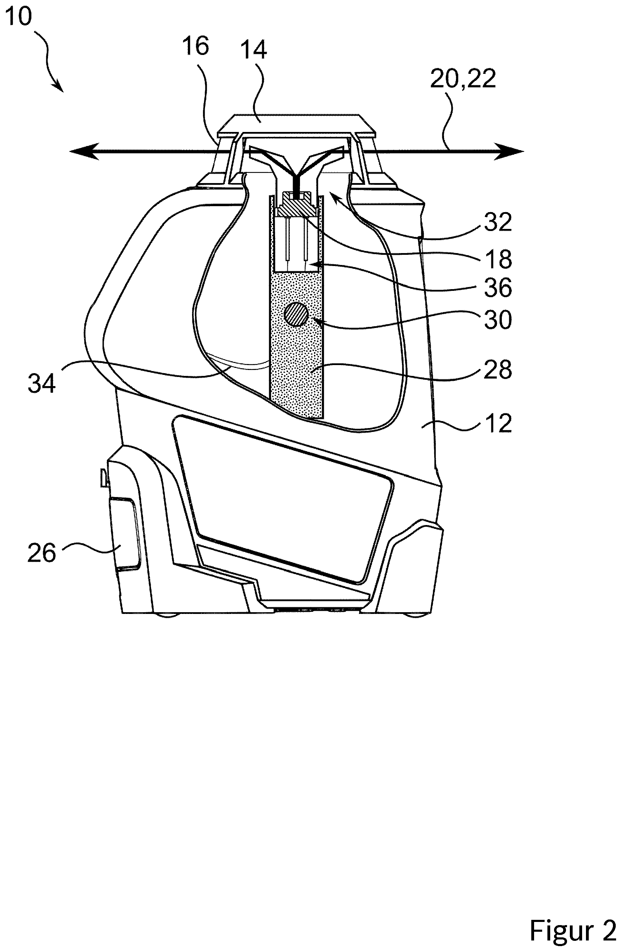

Die Darstellung der Figur 1 zeigt eine Ausführungsform einer erfindungsgemä-βen Laser-Nivelliervorrichtung 10 in einer perspektivischen Seitenansicht. Die Laser-Nivelliervorrichtung 10 weist ein Gehäuse 12 mit Kantenlängen in einem Bereich von 4 bis 15 cm auf. Das Gehäuse 12 besteht im Wesentlichen aus einem polymeren Werkstoff oder einem beispielsweise faserverstärkten Verbundwerkstoff (z.B. faserverstärkter Duroplast oder Thermoplast). Das Gehäuse 12 umgibt die mechanischen Komponenten sowie die optischen und elektronischen Bestandteile (vergleiche insbesondere Figur 2) der Laser-Nivelliervorrichtung 10 und schützt diese vor mechanischer Beschädigung und vermindert die Gefahr von Verunreinigungen. Zur Reduzierung der schädlichen Einwirkungen von Stö-βen gegen die Laser-Nivelliervorrichtung 10, sowie zur komfortableren Handhabung durch den Nutzer, ist das Gehäuse 12 teilweise mit einer Soft-Grip-Komponente belegt. Auf der Oberseite der Laser-Nivelliervorrichtung 10 ist eine Austrittsöffnung vorgesehen, die in Form einer aus dem Gehäuse 12 herausragenden Kuppel 14 mit transparenten Fenstern 16 realisiert ist. Durch die Austrittsöffnung, insbesondere die Fenster 16, kann ein optisches Signal, insbesondere von einer im Gehäuse 12 angeordneten Laserdiode 18 (vgl. insbesondere Figur 2) ausgesendetes Laserlicht 20 zur Erzeugung zumindest einer Lasermarkierung auf einem Objekt, aus dem Gehäuse 12 austreten. Das optische Signal verlässt dabei das Gehäuse 12 unter Aussendung einer einen Winkelbereich von 360° im Wesentlichen überdeckenden Laserebene 22. Die Laserebene 22 wird in der dargestellten Ausführungsform lediglich durch vier kleine Abschattungen (nicht näher dargestellt) unterbrochen, die von den Trägern der Kuppel 14 herrühren.

Die Fenster 16 sind mit einem für das optische Spektrum des optischen Signals transparenten, zumindest jedoch transluzenten Material gefertigt, sodass das Innere der Laser-Nivelliervorrichtung 10 vorteilhaft vor Beschädigungen und Umwelteinflüssen, beispielsweise vor dem Eindringen von Feuchtigkeit und Staub, geschützt wird.

Auf der Rückseite des Gehäuses 12 der Laser-Nivelliervorrichtung 10 befinden sich Bedienelemente, insbesondere ein Schalter 24, dessen Betätigung die im Gehäuse 12 angeordnete Elektronik, insbesondere die Energieversorgung der Laserdiode 18, aktiviert bzw. deaktiviert.

Ferner weist das Gehäuse 12 der Laser-Nivelliervorrichtung 10 ein Batteriefach auf. Ein Batteriefachdeckel 26 schließt das Batteriefach bündig mit der Oberfläche des Gehäuses 12 ab. Das Batteriefach dient der Aufnahme von Batterien (hier nicht näher dargestellt) oder auch Akkumulatoren zur Energieversorgung der Laser-Nivelliervorrichtung 10.

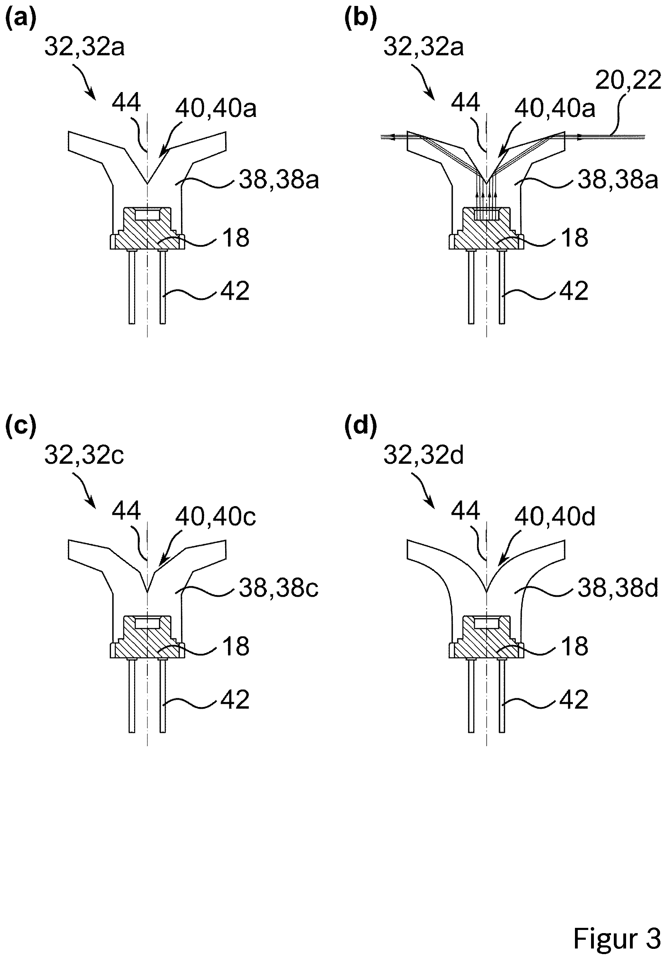

Figur 2 zeigt die gleiche Ausführungsform der Laser-Nivelliervorrichtung 10 aus Figur 1 in einer seitlichen Ansicht, bei der ein Teil des Gehäuses 12 geöffnet dargestellt ist. Neben den in Figur 1 dargestellten Merkmalen ist das zentrale und funktionswesentliche Pendel 28 der Laser-Nivelliervorrichtung 10 dargestellt. Das Pendel 28 besteht in der dargestellten Ausführungsform aus einem Grundkörper (dem sog. Optikträger) und einer kardanischen Aufhängung 30, mittels der das Pendel 28, typischerweise unter Verwendung von Wälzlagern, an/in dem Gehäuse 12 oder an/in einem fest mit dem Gehäuse 12 der Laser-Nivelliervorrichtung 10 verbundenen Bestandteil befestigt ist. Das Pendel 28 ist in der dargestellten Ausführungsform aus einem faserverstärkten duroplastischen Kunststoff mittels Kunststoff-Spritzgießtechnik hergestellt. Das Pendel 28 dient der Aufnahme der wesentlichen optischen Elemente der Laser-Nivelliervorrichtung 10, hier des einstückigen Lasermoduls 32, 32a, 32c, 32d (bestehend aus Laserdiode 18 und Strahlteiler 38, vgl. Figur 3).

Sofern das Pendel 28 nicht mittels einer Arretiervorrichtung (hier nicht näher dargestellt) in einer eingenommenen Position arretiert wird, richtet sich das Pendel 28 selbstnivellierend um zwei Achsen unter Verwendung der kardanischen Aufhängung 30 allseitig frei im Gravitationsfeld der Erde aus. Der Winkelbereich der Ausrichtung des Gehäuses 12, in dem die selbstnivellierende Eigenschaft des Pendels 28, insbesondere dessen präzise Ausrichtung am Lot, gewährleistet ist, umfasst insbesondere 5 Grad bis 15 Grad von der Lotrechten, typischerweise 5 Grad oder 8 Grad. Sofern die Laser-Nivelliervorrichtung 10 eingeschaltet ist, sendet die Laserdiode 18 Laserlicht 20 aus, das mittels eines zur Totalreflexion vorgesehen Negativ-Kegels 40, 40a, 40c, 40d in eine Laserebene 22 umgelenkt wird (vgl. insbesondere Figur 3b). Das emittierte Laserlicht 20 verlässt das Gehäuse 12 durch die Fenster 16 in der Laserebene 22, um eine optische Markierung, insbesondere zumindest eine über einen Winkelbereich von 360° projizierbare Laserlinie, auf einem Objekt zu erzeugen. Die Laserdiode 18 ist über dünne Kabel 34 mit einer nicht näher dargestellten Elektronik verbunden.

Eine Aufnahme 36 des Pendels 28 dient der Aufnahme und der präzisen Ausrichtung des Lasermoduls 32, 32a, 32c, 32d in Bezug auf das Pendel 28 und - da sich das Pendel 28 gemäß Schwerefeld frei ausrichtet - in Bezug auf das Lot. In dem dargestellten Ausführungsbeispiel ist das Lasermodul 32, 32a, 32c, 32d in eine in das Pendel 28 axial eingelassene Aufnahme 36 (Versenkung) eingefügt und mit der Aufnahme 36 über nicht näher dargestellte Befestigungsmittel stabil verbunden, insbesondere verklebt.

Es sei insbesondere angemerkt, dass das Pendel 28 auch mehrere Lasermodule zur Erzeugung mehrerer Laserebenen aufweisen kann. In einer alternativen Ausführungsform der Laser-Nivelliervorrichtung 10 können derart mehrere, unter Verwendung des gleichen erfindungsgemäßen Herstellungsverfahrens hergestellte Lasermodule 32, 32a, 32c, 32d an dem Pendel 28 angeordnet und ausgerichtet sein.

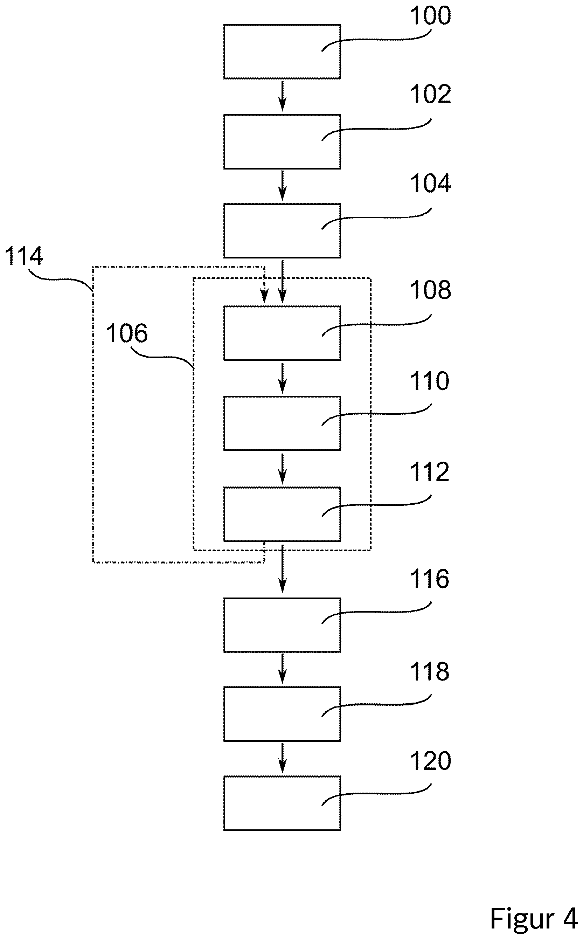

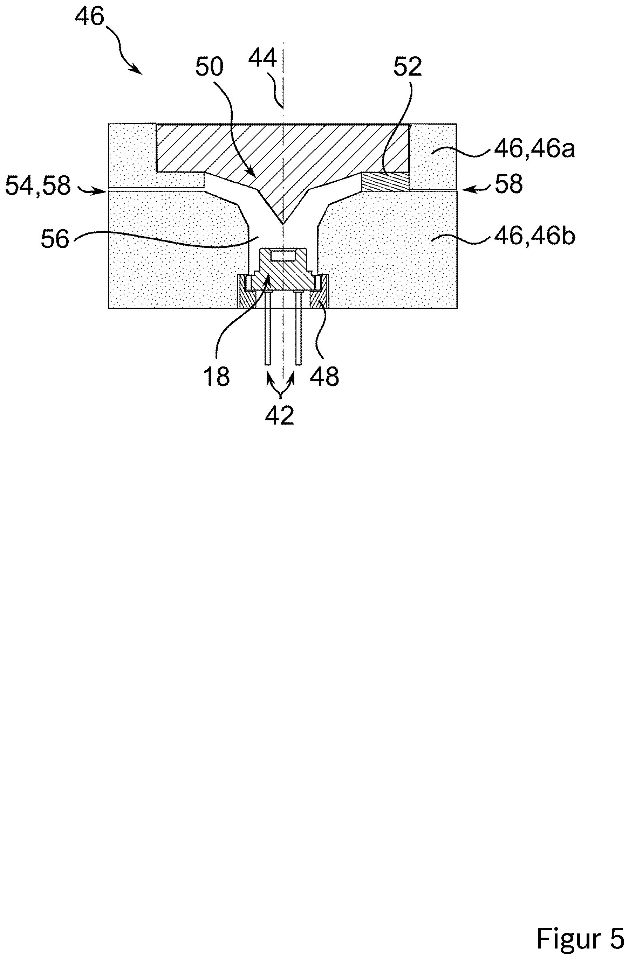

In Figur 3a bis Figur 3d ist in schematischer Seitenansicht jeweils ein erfindungsgemäßes Lasermodul 32, 32a, 32c, 32d dargestellt, bezeichnet mit Bezugszeichen 32a, 32c, 32d. Ein jeweiliges Lasermodul 32, 32a, 32c, 32d ist dazu vorgesehen, eine projizierbare Laserlinie, insbesondere eine über einen Winkelbereich von 360° projizierbare Laserlinie, zu erzeugen und weist zumindest eine Laserdiode 18 zur Emission von Laserlicht 20 in Emissionsrichtung auf. Die projizierbare Laserlinie, insbesondere die über einen Winkelbereich von 360° projizierbare Laserlinie, wird durch Aussenden einer Laserebene 22 realisiert, vgl. insbesondere Figur 3b (und Figur 1). Zur Erzeugung der Laserebene 22 aus von der Laserdiode 18 emittierten Laserlichts 20 weist das jeweilige Lasermodul 32, 32a, 32c, 32d ferner einen Strahlteiler 38, 38a, 38c bzw. 38d auf. Der jeweilige Strahlteiler 38, 38a, 38c bzw. 38d des Lasermoduls 32a, 32c, 32d ist mittels Kunststoff-Spritzgießtechnik in Form eines zur Totalreflektion vorgesehenen Negativ-Kegels 40, 40a, 40c bzw. 40d einstückig, insbesondere form-, kraft- und/oder stoffschlüssig, mit der Laserdiode 18 nach erfindungsgemäßem Herstellungsverfahren gefertigt (vgl. Figuren 4 und 5). Der Negativ-Kegel 40, 40a, 40c, 40d ist dabei dazu vorgesehen, aus dem von der Laserdiode 18 emittierten Laserlicht 20 eine projizierbare Laserlinie, insbesondere eine über einen Winkelbereich von 360° projizierbare Laserlinie, durch Formung einer emittierbaren Laserebene 22 zu erzeugen. In einer Ausführungsform eines Lasermoduls 32, 32a, 32c, 32d kann dieses weitere strahlformende und/oder strahllenkende und/oder die Eigenschaften des Laserlichts 20 beeinflussende optische Elemente, beispielsweise Linsen, Filter, diffraktive Elemente, Spiegel, Reflektoren, optisch transparente Scheiben oder dergleichen, aufweisen. Zur elektrischen Kontaktierung der Laserdiode 18 weist diese zwei elektrische Kontakte 42 auf. Der zur Totalreflektion vorgesehen Negativ-Kegel 40, 40a, 40c, 40d, bevorzugt der Strahlteiler 38, 38a, 38c, 38d, besonders bevorzugt das gesamte Lasermodul 32, 32a, 32c, 32d, ist um eine Kegelachse 44 rotationssymmetrisch realisiert (vgl. Figuren 3a, 3c, 3d).

Die Strahlteiler 38a, 38c und 38d weisen jeweils unterschiedliche Geometrien (Formen) des Negativ-Kegels 40a, 40c, 40d auf. Der Negativ-Kegel 40a in Figur 3a weist einen rotationssymmetrischen Kreiskegelstumpf auf, auf dessen schmaler Stirnfläche ein rotationssymmetrischer Kreiskegel angeschlossen ist. Dabei sind die beiden Kegelabschnitte - Kegelstumpf und daran angeschlossener Kegel - als jeweils gerade und um die Kegelachse 44 rotationssymmetrische Kreiskegel ausgebildet.

Der Negativ-Kegel 40c in Figur 3c weist eine dreiteilige Form auf und basiert auf einem ersten rotationssymmetrischen Kreiskegelstumpf, auf dessen schmaler Stirnfläche ein weiterer rotationssymmetrischer Kreiskegelstumpf anschließt, wobei wiederum auf dessen schmaler Stirnfläche ein rotationssymmetrischer Kreiskegel angeschlossen ist. Dabei sind die jeweiligen Kegelabschnitte - erster Kegelstumpf, weiterer Kegelstumpf und daran angeschlossener Kegel - als jeweils gerade und um die Kegelachse 44 rotationssymmetrische Kreiskegel ausgebildet.

Der Negativ-Kegel 40d in Figur 3d weist einen rotationssymmetrische Kegel auf, der zumindest abschnittsweise eine konkav-gekrümmt ausgebildeten Mantellinie ausgebildet ist. Insbesondere ist der Negativ-Kegel 40d als ein, insbesondere um die Kegelachse 44 rotationssymmetrischer, Kegel mit einer konkav-parabelförmig ausgebildeten Mantellinie ausgebildet.

Figur 4 zeigt in einem schematischen Verfahrensdiagramm die wesentlichen Verfahrensschritte des erfindungsgemäßen Herstellungsverfahrens. Die folgenden Erklärungen beziehen sich ebenfalls auf die schematische Schnitt-Ansicht einer Ausgestaltung eines Spritzgießwerkzeugs in Figur 5. In einem ersten Verfahrensschritt 100 wird die Laserdiode 18 zunächst in ein insbesondere zweihälftiges Spritzgießwerkzeug 46, bestehend aus einer oberen Hälft 46a und einer unteren Hälfte 46b (vgl. Figur 5), eingelegt und grob ausgerichtet. Die Laserdiode 18 wird dabei derart auf einer Justiervorrichtung 48 platziert, dass die elektrischen Kontakte 42 der Laserdiode 18 aus dem Spritzgießwerkzeug 46 frei herausragen (vgl. Figur 5). Das Spritzgießwerkzeug 46 wird anschließend in Verfahrensschritt 102 geschlossen. Das geschlossene Spritzgießwerkzeug 46 bildet fortan zumindest eine Kavität 56 aus, die dem Einspritzen von Kunststoff im Spritzgießverfahren dient.

Anschließend wird die Laserdiode 18 in Verfahrensschritt 104 elektrisch kontaktiert, sodass sie Laserlicht 20 emittiert, welches auf einen im Spritzgießwerkzeug 46 ausgeformten Positiv-Kegel 50 (vgl. Figur 5) auftrifft. Dabei wird das Laserlicht 20 durch Reflektion am Positiv-Kegel 50 geteilt oder aufgespalten und zu einer Laserebene 22 umgelenkt (zu weiteren Details zum Positiv-Kegel 50 siehe Beschreibung zu Figur 5). Der Betrieb der Laserdiode 18 dient der vorteilhaften und zügigen Ausrichtung der Laserdiode 18 im folgenden Verfahrensschritt der Ausrichtung/Justierung (Verfahrensschritt 106).

Anschließend erfolgt in Verfahrensschritt 106 die Ausrichtung der Laserdiode 18 bezüglich des Positiv-Kegels 50 mittels der Justiervorrichtung 48, bis die Kegelachse 44 des Positiv-Kegels 50 und die Emissionsrichtung der Laserdiode 18 kollinear sind (zu weiteren Details zur Justiervorrichtung 48 siehe Beschreibung zu Figur 5). Die kollineare Ausrichtung von Laserdiode 18 bezüglich Positiv-Kegel 50 wird über drei im Spritzgießwerkzeug 46 integrierte, lichtempfindliche, ortsauflösende Sensoren 52 überprüft (Details zu den Sensoren 52 siehe Beschreibung zu Figur 5). Diese drei Sensoren 52 liegen jeweils in der Laserebene 22 - d.h. unter einem rechten Winkel zur Kegelachse 44 (vgl. Figur 5) - und sind unter einem Winkel von jeweils 120° zueinander rotationssymmetrisch um die Kegelachse 44 angeordnet, wobei die Sensoren 52 jeweils auf den Positiv-Kegel 50 ausgerichtet sind. Bei idealer Ausrichtung von Laserdiode 18 bezüglich Positiv-Kegel 50 werden die drei ortsauflösenden Sensoren 52 jeweils an einer vorbestimmten Position, beispielsweise in der Sensormitte, von dem reflektierten Laserlicht 20 getroffen. Das von den Sensoren 52 bereitgestellte Messsignal wird in Teilschritt 108 an eine Steuervorrichtung (hier nicht näher dargestellt) der Justiervorrichtung 48 weitergeleitet. Mit Hilfe eines Steueralgorithmus, beispielsweise unter Verwendung eines Bildverarbeitungsalgorithmus, wird in Teilschritt 110 eine Information über eine Abweichung des reflektierten Laserlichts 20 von einer Sollposition oder Zielposition (hier der Sensormitte) ermittelt. Unter Verwendung dieser Information erfolgt anschließend in Teilschritt 112 eine Ansteuerung der automatisierten, mit Motoren versehenen Justiervorrichtung 48. Die Auslesung der Sensoren in Teilschritt 108, die Bestimmung der Information über die Abweichung in Teilschritt 110 sowie die Ansteuerung der Justiervorrichtung in Teilschritt 112 sind in einer sich wiederholenden Regelschleife, in Figur 4 dargestellt durch den Pfeil 114, realisiert. Die Regelschleife 114 dient der sukzessiven Reduzierung des Abstands des auf den jeweiligen Sensor 52 projizierten Laserlichts 22 von der Sollposition oder Zielposition (hier Sensormitte). Durch Reduzieren dieses Abstands wird gleichzeitig die Kegelachse 44 des Positiv-Kegels 50 und die Emissionsrichtung der Laserdiode 18 kollinear zueinander positioniert bzw. ausgerichtet (,active alignment'). Die Regelschleife 114 wird beendet, wenn die Position des reflektierten Laserlichts 20 die vorbestimmten Positionen auf den Sensoren 52 einnimmt. Dabei sind die vorbestimmten Positionen derart definiert, dass sie exakt dann eingenommen werden, wenn die Kegelachse 44 des Positiv-Kegels 50 und die Emissionsrichtung der Laserdiode 18 kollinear zueinander positioniert bzw. ausgerichtet sind.

Unter Verwendung einer Einspritzdüse 54 wird anschließend in Verfahrensschritt 116 transparenter thermoplastischer Kunststoff, beispielsweise Acrylglas (Polymethylmetacrylate, PMMA) oder Polycarbonat (PC), in die Kavität 56 des Spritzgießwerkzeugs 46 eingespritzt, wobei der Kunststoff den zur Verfügung stehenden Raum der Kavität 56 raumfüllend ausfüllt. Dabei wird der Positiv-Kegel 50 und die Laserdiode 18 zumindest teilweise umspritzt und eine gute Benetzung der exponierten Komponenten oder Bereiche des Positiv-Kegels 50 und der Laserdiode 18 bewirkt. Das Umspritzen oder Umfließen der Laserdiode 18 mit Kunststoff meint insbesondere nicht notwendigerweise das vollständige Umhüllen der Laserdiode 18 mit Kunststoff, sondern vielmehr die Anbindung des einfließenden Kunststoffs an zumindest eine Komponente der Laserdiode 18 durch um-, an- bzw. einspritzen und anschließendes bevorzugt passgenaues Aushärten des Kunststoffs, wobei die Funktionalität der Laserdiode 18 uneingeschränkt erhalten bleibt. Das Umspritzen oder Umfließen des Positiv-Kegels 50 dient hingegen der Abformung der Kegel-Form, sodass sich im umspritzten Kunststoff ein Negativ-Kegel 40, 40a, 40c, 40d ausbildet. Auf diese Weise wird der Strahlteiler 38, 38a, 38c, 38d des Lasermoduls 32, 32a, 32c, 32d mittels Kunststoff-Spritzgießtechnik in Form eines zur Totalreflektion vorgesehenen Negativ-Kegels 40, 40a, 40c, 40d einstückig, insbesondere form-, kraft- und/oder stoffschlüssig, mit der Laserdiode 18 gefertigt.

Nach Beenden des Einspritzvorganges härtet der eingespritzte Kunststoff unter Temperatureinfluss, insbesondere erhöhter Temperatur, aus (Verfahrensschritt 118). Abschließend wird nach Abkühlen des Spritzgießwerkzeugs 46 dieses in Verfahrensschritt 120 wieder geöffnet und das gefertigte Lasermodul 32, bestehend aus Laserdiode 18 mit integriertem optischem Strahlteiler 38, aus dem Spritzgießwerkzeug 46 entnommen.

Es sei an dieser Stelle insbesondere auf Figur 5 verwiesen, die in einer schematischen Schnitt-Darstellung ein Spritzgießwerkzeug 46 darstellt, in dem sich eine Laserdiode 18 befindet. Ferner ist in der Figur 5 eine Trennebene 58 des Spritzgießwerkzeugs 46 zu erkennen, die in Verfahrensschritt 120 der Öffnung des Spritzgießwerkzeugs 46 und somit der Entnahme des gefertigten Lasermoduls 32, 32a, 32c, 32d dient. Die Figur 5 zeigt das Spritzgießwerkzeug 46 im erfindungsgemäßen Herstellungsverfahren zum Zeitpunkt vor der elektrischen Kontaktierung der Laserdiode 18 in Verfahrensschritt 104.

Die Laserdiode 18 befindet sich auf der Justiervorrichtung 48 des Spritzgießwerkzeugs 46. Die Justiervorrichtung 48 ist beweglich und kann durch elektrischen (motorisierten) Antrieb sehr genau verstellt werden. In der dargestellten Ausführungsform der Justiervorrichtung 48 ist diese in Form zumindest zweier ineinander drehbarer Kavitäten als doppelt wirkender Exzenter realisiert, wobei die drehbaren Kavitäten durch einen Elektro- oder Piezoantrieb bewegt werden können. In dem doppelt wirkenden Exzenter wird die Laserdiode 18 aufgenommen und gehalten, wobei die Laserdiode 18 ebenfalls in Verfahrensschritt 104 elektrisch kontaktiert werden kann.

Die Kavität 56 des Spritzgießwerkzeugs 46 besitzt die Form eines Positiv-Kegels 50, dessen Oberfläche eine Oberflächenrauigkeit von < 10 nm besitzt. Zumindest der Positiv-Kegel ist zur Erreichung einer hohen Oberflächengüte in einem diamantzerspanenden Verfahren hergestellt. Der Positiv-Kegel 50 besteht in der in Figur 5 dargestellten Ausführungsform aus zumindest einem rotationssymmetrischen Kreiskegelstumpf, auf dessen schmaler Stirnfläche ein rotationssymmetrischer Kreiskegel angeschlossen ist. Dabei sind die beiden Kegelabschnitte - Kegelstumpf und daran angeschlossener Kegel - als jeweils gerade und rotationssymmetrische Kreiskegel ausgebildet. Die Kegelspitze weist einen Kegelöffnungswinkel von ca. 70° auf, während der Kegelstumpf einen Kegelöffnungswinkel von ca. 145° aufweist.

Es sei darauf hingewiesen, dass auch andere Ausgestaltungen des Positiv-Kegels 50 gewählt werden können, die dann zu entsprechend modifizierten Negativ-Kegeln 40, 40a, 40c, 40d des abgeformten Strahlteilers 38, 38a, 38c, 38d führen. Derartige, unter Verwendung alternativer Formen des Positiv-Kegels 50 gefertigte Strahlteiler 38c, 38d sind in Figur 3c und 3d gezeigt. Da der Positiv-Kegel 50 der Abformung des Negativ-Kegels 40, 40a, 40c, 40d dient, können aus der Figur 3a, 3c und 3d unmittelbar weitere Formen von Positiv-Kegeln 50 entnommen werden (siehe Erklärungen dort): Ein Positiv-Kegel 50, der zur Abformung des Negativ-Kegels 40a der Figur 3a führt, weist einen rotationssymmetrischen Kreiskegelstumpf auf, auf dessen schmaler Stirnfläche ein rotationssymmetrischer Kreiskegel angeschlossen ist. Dabei sind die beiden Kegelabschnitte - Kegelstumpf und daran angeschlossener Kegel - als jeweils gerade und rotationssymmetrische Kreiskegel ausgebildet.

Ein alternativer Positiv-Kegel 50, der zur Abformung des Negativ-Kegels 40c der Figur 3c führt, weist eine dreiteilige Form auf und basiert auf einem ersten rotationssymmetrischen Kreiskegelstumpf, auf dessen schmaler Stirnfläche ein weiterer rotationssymmetrischer Kreiskegelstumpf anschließt, wobei wiederum auf dessen schmaler Stirnfläche ein rotationssymmetrischer Kreiskegel angeschlossen ist. Dabei sind die jeweiligen Kegelabschnitte - erster Kegelstumpf, weiterer Kegelstumpf und daran angeschlossener Kegel - als jeweils gerade und rotationssymmetrische Kreiskegel ausgebildet.

Ein weiterer alternativer Positiv-Kegel 50, der zur Abformung des Negativ-Kegels 40d der Figur 3d führt, weist einen rotationssymmetrische Kegel auf, der zumindest abschnittsweise eine konkav-gekrümmt ausgebildeten Mantellinie ausgebildet ist. Insbesondere kann der Positiv-Kegel 50 als ein, insbesondere rotationssymmetrischer, Kegel mit einer konkav-parabelförmig ausgebildeten Mantellinie ausgebildet sein.

Ferner weist das Spritzgießwerkzeug 46 drei lichtempfindliche ortsauflösende Sensoren 52 auf, die dazu vorgesehen sind, auftreffendes Laserlicht zu detektieren. In diesem Ausführungsbeispiel sind die Sensoren 52 beispielhaft als ortsauflösender CCD-Chip (Digitalkamera) realisiert. Die drei Sensoren liegen jeweils in der Laserebene 22 - d.h. unter einem rechten Winkel zur Kegelachse 44 - und sind unter einem Winkel von jeweils 120° zueinander rotationssymmetrisch um die Kegelachse 44 angeordnet, wobei die Sensoren 52 jeweils auf den Positiv-Kegel 50 ausgerichtet sind.

## Patentansprüche

1. Herstellungsverfahren für ein Lasermodul (32, 32a, 32c, 32d) einer Laser-Nivelliervorrichtung (10), wobei das Lasermodul (32, 32a, 32c, 32d) dazu vorgesehen ist, eine projizierbare Laserlinie, insbesondere eine über einen Winkelbereich von 360° projizierbare Laserlinie, zu erzeugen und zumindest eine Laserdiode (18) zur Emission von Laserlicht (20) in Emissionsrichtung aufweist, **gekennzeichnet durch zumindest** einen Verfahrensschritt (116), bei dem ein Strahlteiler (38, 38a, 38c, 38d) des Lasermoduls (32, 32a, 32c, 32d) mittels Kunststoff-Spritzgießtechnik in Form eines zur Totalreflektion vorgesehenen Negativ-Kegels (40, 40a, 40c, 40d) einstückig, form- und/oder stoffschlüssig, mit der Laserdiode (18) gefertigt wird.

2. Herstellungsverfahren nach Anspruch 1, **dadurch gekennzeichnet, dass** der Strahlteiler (38, 38a, 38c, 38d) in Form des Negativ-Kegels (40, 40a, 40c, 40d) durch Umspritzen eines Positiv-Kegels (50) gefertigt wird.

3. Herstellungsverfahren nach Anspruch 2, **dadurch gekennzeichnet, dass** der Positiv-Kegel als ein gerader, insbesondere rotationssymmetrischer, Kreiskegel mit einem Kegelöffnungswinkel von 90° ausgebildet ist.

4. Herstellungsverfahren nach Anspruch 2, **dadurch gekennzeichnet, dass** der Positiv-Kegel (50) als ein, insbesondere rotationssymmetrischer, Kegel mit einer zumindest abschnittsweise konkav-gekrümmt ausgebildeten Mantellinie ausgebildet ist.

5. Herstellungsverfahren nach Anspruch 2 oder Anspruch 4, **dadurch gekennzeichnet, dass** der Positiv-Kegel (50) als ein, insbesondere rotationssymmetrischer, Kegel mit einer konkav-parabelförmig ausgebildeten Mantellinie ausgebildet ist.

6. Herstellungsverfahren nach einem der Ansprüche 2-5, **dadurch gekennzeichnet, dass** die Laserdiode (18) und der zu umspritzende Positiv-Kegel (50) in einem weiteren Verfahrensschritt (106) mittels einer Justiervorrichtung (48) derart zueinander ausgerichtet werden, insbesondere die Laserdiode (18) bezüglich des zu umspritzenden Positiv-Kegels (50) derart ausgerichtet wird, dass die Kegelachse (44) des Positiv-Kegels (50) und die Emissionsrichtung der Laserdiode (18) kollinear sind.

7. Herstellungsverfahren nach Anspruch 6, **dadurch gekennzeichnet, dass** die Laserdiode (18) während des Verfahrensschritts (106) der Ausrichtung betrieben wird.

8. Herstellungsverfahren nach Anspruch 7, **dadurch gekennzeichnet, dass** der von der Laserdiode (18) während des Betriebs emittierte Laserstrahl (20) am Positiv-Kegel (50) geteilt und in unterschiedliche Richtungen reflektiert wird, wobei eine Position des reflektierten Laserlichts (20) mittels zumindest zweiter, bevorzugt dreier, lichtempfindlicher Sensoren (52) detektiert wird.

9. Herstellungsverfahren nach Anspruch 8, **dadurch gekennzeichnet, dass** die Ausrichtung beendet wird, wenn die Position des reflektierten Laserlichts (20) vorbestimmte Positionen einnimmt.

10. Herstellungsverfahren nach Anspruch 8-9, **dadurch gekennzeichnet, dass** die Ausrichtung unter Verwendung einer automatisierten Justiervorrichtung (48) erfolgt, wobei die Justiervorrichtung (48) unter Anwendung einer mit den Sensoren (52) gekoppelten Regelschleife betrieben wird.

11. Herstellungsverfahren nach einem der Ansprüche 2-10, **dadurch gekennzeichnet, dass** der Positiv-Kegel (50) eine Oberflächenrauigkeit von weniger als 10 nm, bevorzugt von weniger als 5 nm und besonders bevorzugt von weniger als 1 nm besitzt.

12. Herstellungsverfahren nach einem der Ansprüche 1-11, **dadurch gekennzeichnet, dass** der Strahlteiler (38, 38a, 38c, 38d) aus transparentem Kunststoff, insbesondere aus thermoplastischem oder aus vernetzendem Kunststoff, mittels Kunststoff-Spritzgießtechnik gefertigt wird.

13. Lasermodul (32, 32a, 32c, 32d) einer Laser-Nivelliervorrichtung (10), hergestellt nach einem Verfahren gemäß zumindest einem der Ansprüche 1-12.

14. Laser-Nivelliervorrichtung (10) aufweisend zumindest ein Gehäuse (12), ein in dem Gehäuse (12) pendelbar angeordnetes Pendel (28) sowie zumindest ein an dem Pendel (28) angeordnetes Lasermodul (32, 32a, 32c, 32d) zur Erzeugung einer projizierbaren Laserlinie, insbesondere einer über einen Winkelbereich von 360° projizierbaren Laserlinie, hergestellt nach einem Verfahren gemäß zumindest einem der Ansprüche 1-13, **dadurch gekennzeichnet, dass** ein Strahlteiler (38, 38a, 38c, 38d) des Lasermoduls (32, 32a, 32c, 32d) mittels Kunststoff-Spritzgießtechnik in Form eines zur Totalreflektion vorgesehenen Negativ-Kegels (40, 40a, 40c, 40d) einstückig, form- und/oder stoffschlüssig, mit der Laserdiode (18) realisiert ist.

## Claims

1. Production method for a laser module (32, 32a, 32c, 32d) of a laser levelling device (10), the laser module (32, 32a, 32c, 32d) being provided to generate a projectable laser line, in particular a laser line that is projectable over an angular range of 360°, and having at least one laser diode (18) for emitting laser light (20) in the emission direction, **characterized by at least** one method step (116) in which a beam splitter (38, 38a, 38c, 38d) of the laser module (32, 32a, 32c, 32d) is manufactured, by means of plastic injection moulding, in the form of a negative cone (40, 40a, 40c, 40d) which is provided for total-internal reflection and which is in one piece with and/or interlockingly and/or integrally connected to the laser diode (18).

2. Production method according to Claim 1, **characterized in that** the beam splitter (38, 38a, 38c, 38d) is manufactured in the form of the negative cone (40, 40a, 40c, 40d) by implementing insert moulding around a positive cone (50).

3. Production method according to Claim 2, **characterized in that** the positive cone is in the form of a right circular cone, in particular a rotationally symmetric circular cone, with an opening angle of 90°.

4. Production method according to Claim 2, **characterized in that** the positive cone (50) is in the form of a cone, in particular a rotationally symmetric cone, with a generatrix formed with concave curvature at least in certain sections.

5. Production method according to Claim 2 or Claim 4, **characterized in that** the positive cone (50) is in the form of a cone, in particular a rotationally symmetric cone, with a concave-parabolic generatrix.

6. Production method according to any of Claims 2-5, **characterized in that** the laser diode (18) and the positive cone (50) to be subjected to insert moulding are aligned relative to one another in a further method step (106) by means of an adjustment device (48), in particular the laser diode (18) is aligned in such a way with respect to the positive cone (50) to be subjected to insert moulding that the cone axis (44) of the positive cone (50) and the emission direction of the laser diode (18) are collinear.

7. Production method according to Claim 6, **characterized in that** the laser diode (18) is operated during the alignment method step (106).

8. Production method according to Claim 7, **characterized in that** the laser beam (20) emitted by the laser diode (18) during operation is split at the positive cone (50) and is reflected in different directions, with a position of the reflected laser light (20) being detected by means of at least two, preferably three, light-sensitive sensors (52).

9. Production method according to Claim 8, **characterized in that** the alignment is completed when the position of the reflected laser light (20) adopts predetermined positions.

10. Production method according to Claims 8-9, **characterized in that** the alignment is implemented using an automated adjustment device (48), the adjustment device (48) being operated using a control loop coupled to the sensors (52).

11. Production method according to any of Claims 2-10, **characterized in that** the positive cone (50) has a surface roughness of less than 10 nm, preferably less than 5 nm and particularly preferably less than 1 nm.

12. Production method according to any of Claims 1-11, **characterized in that** the beam splitter (38, 38a, 38c, 38d) is manufactured from transparent plastic, in particular thermoplastic or crosslinking plastic, by means of plastic injection moulding.

13. Laser module (32, 32a, 32c, 32d) of a laser levelling device (10), produced in accordance with a method according to at least one of Claims 1-12.

14. Laser levelling device (10) having at least one housing (12), a pendulum (28) arranged so to be able to oscillate within the housing (12) and at least one laser module (32, 32a, 32c, 32d) which is arranged on the pendulum (28) and serves to generate a projectable laser line, in particular a laser line that is projectable over an angular range of 360°, produced in accordance with a method according to at least one of Claims 1-13, **characterized in that** a beam splitter (38, 38a, 38c, 38d) of the laser module (32, 32a, 32c, 32d) is realized, by means of plastic injection moulding, in the form of a negative cone (40, 40a, 40c, 40d) which is provided for total-internal reflection and which is in one piece with and/or interlockingly and/or integrally connected to the laser diode (18).

## Revendications

1. Procédé de fabrication d'un module laser (32, 32a, 32c, 32d) d'un dispositif de nivellement laser (10), le module laser (32, 32a, 32c, 32d) étant prévu pour générer une raie d'émission laser projetable, notamment une raie d'émission projetable sur une plage angulaire de 360°, et comportant au moins une diode laser (18) destinée à émettre la lumière laser (20) dans la direction d'émission, **caractérisé par** au moins une étape de procédé (116), dans laquelle un diviseur de faisceau (38, 38a, 38c, 38d) du module laser (32, 32a, 32c, 32d) est réalisé au moyen d'une technique de moulage par injection de matière synthétique sous la forme d'un cône négatif (40, 40a, 40c, 40d) prévu pour la réflexion totale, d'une seule pièce avec la diode laser (18) par une liaison par complémentarité de formes et/ou une liaison de matière.

2. Procédé de fabrication selon la revendication 1, **caractérisé en ce que** le diviseur de faisceau (38, 38a, 38c, 38d) est réalisé sous la forme du cône négatif (40, 40a, 40c, 40d) par surmoulage d'un cône positif (50) .

3. Procédé de fabrication selon la revendication 2, **caractérisé en ce que** le cône positif est conçu comme un cône circulaire droit, en particulier à symétrie de rotation, avec un angle d'ouverture de cône de 90°.

4. Procédé de fabrication selon la revendication 2, **caractérisé en ce que** le cône positif (50) est réalisé sous la forme d'un cône, en particulier d'un cône à symétrie de rotation, avec une génératrice incurvée de manière concave au moins par portions.

5. Procédé de fabrication selon la revendication 2 ou la revendication 4, **caractérisé en ce que** le cône positif (50) est réalisé sous la forme d'un cône, notamment à symétrie de rotation, avec une génératrice de forme concave-parabolique.

6. Procédé de fabrication selon l'une des revendications 2 à 5, **caractérisé en ce que** la diode laser (18) et le cône positif (50) à surmouler sont orientés l'un par rapport à l'autre dans une autre étape de procédé (106) au moyen d'un dispositif de réglage (48), notamment la diode laser (18) est orientée par rapport au cône positif (50) à surmouler de manière à ce que l'axe de cône (44) du cône positif (50) et la direction d'émission de la diode laser (18) soient colinéaires.

7. Procédé de fabrication selon la revendication 6, **caractérisé en ce que** la diode laser (18) est utilisée pendant l'étape d'orientation (106).

8. Procédé de fabrication selon la revendication 7, **caractérisé en ce que** le faisceau laser (20) émis par la diode laser (18) pendant le fonctionnement est divisé au niveau du cône positif (50) et réfléchi dans différentes directions, une position de la lumière laser réfléchie (20) étant détectée au moyen d'au moins deux, de préférence trois, capteurs photosensibles (52) .

9. Procédé de fabrication selon la revendication 8, **caractérisé en ce que** l'orientation est terminée lorsque la position de la lumière laser réfléchie (20) prend des positions prédéterminées.

10. Procédé de fabrication selon la revendication 8 ou 9, **caractérisé en ce que** l'orientation est effectuée à l'aide d'un dispositif de réglage automatisé (48), le dispositif de réglage (48) étant utilisé à l'aide d'une boucle de régulation couplée aux capteurs (52).

11. Procédé de fabrication selon l'une des revendications 2 à 10, **caractérisé en ce que** le cône positif (50) présente une rugosité de surface inférieure à 10 nm, de préférence inférieure à 5 nm et de manière particulièrement préférée inférieure à 1 nm.

12. Procédé de fabrication selon l'une des revendications 1 à 11, **caractérisé en ce que** le diviseur de faisceau (38, 38a, 38c, 38d) est réalisé à partir d'une matière synthétique transparente, notamment une matière synthétique thermoplastique ou réticulable, par une technique de moulage par injection de matière synthétique.

13. Module laser (32, 32a, 32c, 32d) d'un dispositif de nivellement laser (10), réalisé par un procédé selon l'une au moins des revendications 1-12.

14. Dispositif de nivellement laser (10) comportant au moins un boîtier (12), un pendule (28) disposé de manière pendulaire dans le boîtier (12) et au moins un module laser (32, 32a, 32c, 32d) disposé sur le pendule (28) et destiné à générer une raie d'émission laser projetable, en particulier une raie d'émission laser projetable sur une plage angulaire de 360°, réalisé selon un procédé selon l'une au moins des revendications 1 à 13, **caractérisé en ce qu'**un diviseur de faisceau (38, 38a, 38c, 38d) du module laser (32, 32a , 32c, 32d) est réalisé au moyen d'une technique de moulage par injection de matière synthétique sous la forme d'un cône négatif (40, 40a, 40c, 40d) prévu pour la réflexion totale, d'une seule pièce avec la diode laser (18) par une liaison par complémentarité de formes et/ou une liaison de matière.
